# EUROPÄISCHE PATENTSCHRIFT

(11) **EP 2 009 134 B1**
(45) Veröffentlichungstag und Bekanntmachung des Hinweises auf die Patenterteilung: **27.02.2013**
(21) Anmeldenummer: 08157310.7
(22) Anmeldetag: 30.05.2008
(51) Int. Cl.: C23C 14/32, C23C 14/06, C23C 14/34

(54) **Schichtsystem zur Bildung einer Oberflächenschicht auf einer Oberfläche eines Substrats, sowie Lichtbogenverdampfungsquelle zur Herstellung eines Schichtsystems**
Layer system for creating a surface layer on a surface of a substrate, vaporisation source for manufacturing a layer system
Système de couche destiné à la formation d'une couche superficielle à la surface d'un substrat, tout comme source d'évaporation à arc électrique destinée à la fabrication d'un système de couche

(30) Priorität: 25.06.2007 EP 07110938
(43) Veröffentlichungstag der Anmeldung: 31.12.2008
(73) Patentinhaber: Sulzer Metaplas GmbH, 51427 Bergisch-Gladbach (DE)
(72) Erfinder: Vetter, Dr., Jörg, 51469 Bergisch Gladbach (DE)
(74) Vertreter: Sulzer Management AG

(56) Entgegenhaltungen:
- EP-A- 0 560 045
- EP-A- 1 391 533
- WO-A-2004/059030
- DE-A1-102007 039 193
- JP-A- 2000 297 365
- US-A1- 2005 042 474

## Beschreibung

Die Erfindung betrifft eine Schichtsystem zur Bildung einer Oberfläche auf einem Substrat, eine Verdampfungsquelle zur Herstellung eines Schichtsystems, sowie ein Substrat, insbesondere ein Werkzeug mit einem erfindungsgemässen Schichtsystem gemäss dem Oberbegriff des unabhängigen Anspruchs der jeweiligen Kategorie.

Die Herstellung leistungsfähiger Werkzeuge und Bauteile wird meistens durch eine Beschichtung von deren Oberflächen realisiert. Eine wichtige Klasse solcher beschichteten Substrate sind Werkzeuge, neben anderen insbesondere zerspanende Werkzeuge sowie Bauteile, vor allem Verschleissteile für Maschinen in allen möglichen Ausführungsformen. Typische Substratmaterialien, die beschichtet werden, sind unter anderem Werkzeugstähle und Hartmetalle, aber auch alle möglichen anderen Substratmaterialien.

Ein bekanntes Problem beim Beschichten dieser Werkstoffe ist dabei, dass beide eine hohe Oxidationsrate an Luft bereits um 500°C aufweisen und bereits bei relativ niedrigen Temperaturen (ca. HSS 550°C, Hartmetall 650°C) erweichen.

Daher kommen insbesondere für die Hartbearbeitung von Stählen bevorzugt auch keramische Schneidkörper, z.B. auf der Basis von kubischem Bornitrid zum Einsatz. So werden zum Beispiel zur Hochgeschwindigkeitsbearbeitung von Al-Legierungen und Grauguß vermehrt verschiedenste SiN-Keramiken eingesetzt. Die Keramiken erweisen sich dabei als wesentlich beständiger gegenüber den metallischen Werkzeugmaterialien. Eine weitere Leistungssteigerung kann durch geeignete Beschichtung der Werkzeuge erreicht werden.

Die aus dem Stand der Technik bekannten Hartstoffschichten basieren dabei häufig auf klassischen Verbindungen wie TiN, TiNC, CrN. Diese bekannten Hartschichten haben in Bezug auf ihren Einsatzbereich aufgrund ihrer speziellen physikalischen Eigenschaften jedoch ihre Grenzen, vor allem bezüglich der Temperaturbelastbarkeit. Einerseits sinkt nämlich die Härte bei erhöhten Temperaturen merklich ab, andererseits setzt bereits bei relativ niedrigen Temperaturen eine Oxidation ein, die zu erhöhtem Schichtverschleiß bei der Einsatztemperatur führen kann.

Um diese Probleme zu umgehen wurden im wesentlichen zwei Schichtklassen entwickelt, die eine Oxidationsbeständigkeit im Bereich bis zu 1000 °C aufweisen und auch bezüglich der Härte verbesserte Eigenschaften haben.

Die eine Schichtklasse betrifft Al-haltige Basisschichten wie AlTiN und AlCrN, wobei, je nach Anforderung zusätzliche Elemente hinzulegiert werden können. Typische Verbindungen aus diesem Bereich sind Verbindungen der Form AlTiXNCO, wobei X z.B. Cr oder ein anderes Metall ist (siehe z.B. WO 2004/059030).

Ein anderer im Stand der Technik beschrittener Weg zur Leistungssteigerung beschichteter Werkzeuge besteht in der Kombination von klassischen Hartstoffschichten als Trägerschicht kombiniert mit Finish-Schichten als Funktionsschicht. Insbesondere sind hier als Finish-Schichten die hoch Sihaltigen Schichten (10at-% oder mehr; at-% bedeutet dabei im Rahmen dieser Anmeldung "Atomprozent") des Typs MeSiXNCO-Schicht (X weitere Metalle oder B) wie TiSiN zu nennen, die eine deutlich verbesserte Temperaturbelastung ermöglichen.

Daneben ist es weiterhin beispielsweise bekannt, oxidische Keramikschichen wie Al₂O₃ mittels CVD-Verfahren auf Wendeschneidplatten abzuscheiden, um den Verschleißprozessen bei erhöhten Kontakttemperaturen, insbesondere beim Drehen begegnen zu können.

Im Stadium der Erforschungen sind darüber hinaus Bor-basierte Schichten, wie zum Beispiel B₄C oder auch kubische BN Schichten. Allerdings hat kubisches BN den entscheidenden Nachteil, dass es äußert kompliziert darstellbar ist. Dies ist vor allem durch Schwierigkeiten beim Schichtwachstum selbst, aber auch durch die hohen Eigenspannungen in den Schichten bedingt.

Im Bereich der Hochtemperaturwerkstoffe wurden in den letzten Jahren Volumenkeramiken auf der Basis von SiCN erzeugt, die sich durch hohe Härten und eine Verbesserung der Oxidationsbeständigkeit gegenüber SiC und Si₃N₄ auszeichnen. Deren besondere Eigenschaften sind durch die komplexen kovalenten chemischen Bindungen und die niedrige Diffusionsrate von Sauerstoff in der amorphen Struktur des SiCN begründet.

Allen bisherigen Bemühungen zum Trotz ist es aber nur teilweise gelungen, Beschichtungen zur Verfügung zu stellen, die den immer höheren Anforderungen an die mechanischen Eigenschaften, wie zum Beispiel Härte, Druckeigenspannungen und Zähigkeit, tribologische Eigenschaften wie Adhäsionsneigung bei höheren Temperaturen sowie Reibung, die Oxidationsresistenz, Phasenstabilität und anderen charakteristischen Eigenschaften, vor allem auch bei extremen Temperaturen gerecht zu werden.

Ausserdem sind die oben beschriebenen leistungsfähigeren Schichten verfahrenstechnisch sehr schwer herstellbar, und die damit beschichteten Werkzeuge sehr teuer sind, so dass sich vom Standpunkt der Wirtschaftlichkeit betrachtet, eine Beschichtung in vielen Fällen nicht lohnt, bzw. solcherart beschichtete Werkzeuge nur einen begrenzten Markt finden. Die Aufgabe der Erfindung ist es daher, eine verbesserte Beschichtungen für ein Substrat, insbesondere für ein Werkzeug oder ein Verschleissteil bereitzustellen, die die aus dem Stand der Technik bekannten Probleme überwindet, und insbesondere ein sich tribologisch positiv auswirkendes Oxidationsverhalten und Phasenstabilität, verbesserte mechanische Eigenschaften, vor allem, aber nicht nur, in Bezug auf die Härte und Druckeigenspannungen aufweist und auch unter extremen Temperaturbedingungen einsetzbar ist.

Eine weitere Aufgabe der Erfindung ist es, eine Lichtbogenverdampfungsquelle bereitzustellen, mit der die neuen verbesserten Hartschichten hergestellt werden können.

Die diese Aufgaben lösenden Gegenstände der Erfindung sind durch die Merkmale der jeweiligen unabhängigen Ansprüche gekennzeichnet.

Die jeweiligen abhängigen Ansprüche beziehen sich auf besonders vorteilhafte Ausführungsformen der Erfindung.

Die Erfindung betrifft somit eine Schichtsystem zur Bildung einer Oberflächenschicht auf einer Oberfläche eines Substrats, insbesondere auf der Oberfläche eines Werkzeugs, wobei das Schichtsystem mindestens eine erste Hartschicht der Zusammensetzung (AlₐMg_{b}Cr_{c}Me_{d}BₑAXₘSiₖ)_{α}(NᵤCᵥO_{w})_{β} umfasst, mit (a+b+c+d+e+m+k) = α, (u+v+w) = β, und (α+β) =100, wobei 40 ≤α≤ 60 gilt, und wobei Me mindestens ein Element aus der Gruppe der chemischen Elemente bestehend aus den Nebengruppen IVb, Vb und VIb des Periodensystems der chemischen Elemente ist. Die Komponenten AX ist mindestens ein Element aus der Gruppe der chemischen Elemente bestehend aus den Elementen der Hauptgruppen Ia und den Elementen Be, Ca, Sr, Ba und den Elementen der Nebengruppen VIIb, VIIIb, Ib, IIb, IIIb und den Elementen der Gruppe der Lanthanoide des Periodensystems der Elemente, wobei 0.004 ≤ m < 60, bevorzugt 0.01 ≤ m < 50 gilt. Erfindungsgemäss ist 0.4 ≤ a < 58 und 0.04 ≤ b ≤ 12 und 18 ≤ c ≤ 42.

Diese Formulierung ist gleichbedeutend damit, dass ein Schichtsystem zur Bildung einer Oberflächenschicht auf einer Oberfläche eines Substrats, insbesondere auf der Oberfläche eines Werkzeugs vorgeschlagen wird, wobei das Schichtsystem mindestens eine erste Hartschicht der Zusammensetzung (AlₐMg_{b}Cr_{c}Me_{d}BₑAₘSiₖ)G umfasst, mit (a+b+c+d+e+m+k) = 100, und G mindestens ein Element aus der Gruppe der chemischen Elemente bestehend aus N, C und O ist. Me ist mindestens ein Element aus der Gruppe der chemischen Elemente bestehend aus den Nebengruppen IVb, Vb und VIb des Periodensystems der chemischen Elemente ist, und A ist mindestens ein Element aus der Gruppe der chemischen Elemente bestehend aus, den Elementen der Hauptgruppen Ia, IIa, und den Elementen der Nebengruppen VIIb, VIIIb, Ib, IIb, IIIb, und den Elementen der Gruppe der Lanthanoide des Periodensystems der Elemente, wobei 0.01 ≤ m < 100 ist. Erfindungsgemäss ist dabei 1 ≤ a ≤ < 97 und 0.1 ≤ b s 20 und 30 ≤ c ≤ 70. In dieser Formulierung ist die Summe (a+b+c+d+e+m+k) auf 100 bezogen und nicht wie im Anspruch 1 der vorliegenden Anmeldung auf α. Obwohl die Formulierung (a+b+c+d+e+m+k) = 100 im wesentlichen identischen zu (a+b+c+d+e+m+k) = α ist, sofern die Gruppe G nicht näher spezifiziert ist, kann (a+b+c+d+e+m+k) = 100 in zweifelsfällen zu Unklarheiten führen, so dass im Folgenden die klarere Formulierung (a+b+c+d+e+m+k) = a verwendet wird.

Zur besseren Unterscheidung wird ausserdem im Folgenden anstelle des Symbols A für die Komponente A in der Formeleinheit (AlₐMg_{b}Cr_{c}Me_{d}BₑAₘSiₖ) das Symbol AX verwendet.

Die gegenüber dem Stand der Technik erheblich verbesserte Leistungsfähigkeit der Werkzeuge und Bauteile wird somit erfindungsgemäss dadurch erreicht, dass die entsprechenden Substrate mit einer Hartschicht der Zusammensetzung (AlₐMg_{b}Cr_{c}Me_{d}BₑAXₘSiₖ)G beschichtet werden, wobei G in an sich bekannter Zusammensetzung mindestens ein Element aus der Gruppe Stickstoff (N), Kohlenstoff (C) und Sauerstoff (O) ist, als o z.B. für (NᵤCᵥO_{w})_{β} steht und Me mindestens ein Metall aus der Gruppe der chemischen Elemente bestehend aus den Elementen aus den Nebengruppen IVb, Vb, VIb des Periodensystems der Elemente ist, und A mindestens ein Element aus der Gruppe der chemischen Elemente bestehend aus, den Elementen der Hauptgruppen Ia, IIa, und den Elementen der Nebengruppen VIIb, VIIIb, Ib, IIb, IIIb, und den Elementen der Gruppe der Lanthanoide des Periodensystems der Elemente ist.

Die deutlich verbesserten Eigenschaften der erfindungsgemässen Schichtsysteme, vor allem in Bezug auf Härte, Druckeigenspannungen Oxidationsfestigkeit und Phasenstabilität bis hinauf zu Temperaturen von 1.200°C und mehr, konnten dabei dadurch erreicht werden, dass erfindungsgemäss der Anteil an Aluminium (Al) auf 0.4 ≤ a ≤ 58 beschränkt ist, und gleichzeitig der Anteil an Magnesium (Mg) auf 0.04 ≤ b ≤ 12 und der Anteil an Chrom (Cr) auf 18 ≤ c ≤ 42 beschränkt ist.

Die Nebengruppen IVb, Vb, VIb, aus denen das Metall Me auswählbar ist, bestehen aus den Elementen Titan (Ti), Zirkon (Zr), Hafnium (Hf) der Gruppe IVb, den Elementen Vanadium (V), Niob (Nb), Tantal (Ta) der Gruppe Vb und Chrom (Cr), Molybdän (Mo) und Wolfram (W) der Nebengruppe VIb des Periodensystems der Elemente.

Die Hauptgruppen Ia, IIa des Periodensystems der Elemente aus denen unter anderem die Formelkomponente AX auswählbar ist, besteht bekanntlich aus den Elementen Wasserstoff (H), Lithium (Li), Natrium (Na), Kalium (K), Rubidium (Rb), Cäsium (Cs) und Francium (Fr) aus der Hauptgruppe Ia, und aus den Elementen Beryllium (Be), Magnesium (Mg), Calcium (Ca), Strontium (Sr), Barium (Ba) und Radium (Ra) der Gruppe IIa.

Die Nebengruppe Ib besteht aus den chemischen Elementen Kupfer (Cu), Silber (Ag), Gold (Au) und Terbium (Tb), die Nebengruppe IIb besteht aus den chemischen Elementen Zink (Zn), Cadmium (Cd), Quecksilber (Hg) und Dysprosium (Dy), während die Nebengruppe IIIb aus den chemischen Elementen Scandium (Sc), Yttrium (Y), Lanthan (La) und Actinium (Ac) besteht.

Die weiteren Nebengruppen VIIb und VIIIb, aus denen die Komponente AX der Formeleinheit (AlₐMg_{b}Cr_{c}Me_{d}BₑAXₘSiₖ) ebenfalls ausgewählt sein kein, bestehen aus den chemischen Elementen Mangan (Mn), Technetium (Tc), Rhenium (Re) der Nebengruppe VIIb, und Eisen (Fe), Ruthenium (Ru), Osmium(Os), Kobalt (Co), Rhodium (Rh), Iridium (Ir), Nickel (Ni), Palladium (Pd) und Platin (Pt) der Nebengruppe VIIIb des Periodensystems der chemischen Elemente.

Zu der Gruppe der Lanthanoide zählen bekanntermassen die chemischen Elemente Cer (Ce), Praseodym (Pr), Neodym (Nd), Promethium (Pm), Samarium (Sm), Europium (Eu), Gadolinium (Gd), Terbium (Tb), Dysprosium (Dy), Holmium (Ho), Erbium (Er), Thulium (Tm), Ytterbium (Yb) und Lutetium (Lu).

Überraschender Weise hat sich nun gezeigt, dass die aus dem Stand der Technik bekannte Hartschichten, die die eingangs erwähnten Nachteile aufweisen, wie insbesondere mangelnde Oxidationsbeständigkeit und Phasenstabilität vor allem bei höheren Temperaturen, wie sie z.B. bei Hochleitungswerkzeugen im Betriebszustand sehr häufig auftreten, durch die oben angegebene Einschränkung des Aluminium-, Magnesium- und Chromgehalts in der erfindungsgemässen Verbindung (AlₐMg_{b}Cr_{c}Me_{d}BₑAXₘSiₖ)G entscheidend verbessern lassen, wobei es durch geeignete Wahl der chemischen Zusammensetzungen durch die vorliegende Erfindung erstmals gelungen ist, Oxidationsbeständigkeit, Phasenbeständigkeit, Härte, Druckeigenspannung und andere entscheidende Grössen, wie z.B. die Haftfestigkeit gleichzeitig in einer (AlₐMg_{b}Cr_{c}Me_{d}BeAXₘSiₖ)G - Schicht zu optimieren.

Dabei sind, sofern nicht anders ausdrücklich erwähnt, im Rahmen dieser Anmeldung die durch Indizes an den chemischen Elementen bzw. an den die chemischen Elementen repräsentierenden Symbolen indizierten Mengenangaben durchweg Atomprozent (at-%).

Insbesondere hat sich gezeigt, dass sich die Schichten des erfindungsgemässen Schichtsystems auch vorteilhaft mit bereits bekannten Schichten und Schichtsystemen zu neuen Schichtsystemen kombinieren lassen, so dass durch die vorliegende Erfindung völlig neue Schichtsysteme mit im Vergleich zum Stand der Technik in fast jeder Hinsicht verbesserten Eigenschaften bereitgestellt werden.

So können in einem erfindungsgemässen Schichtsystem verschiedenartige Schichten, die ganz unterschiedliche Funktionen haben können, hervorragend mit einer ersten Hartschicht kombiniert werden, ohne dass z.B. Probleme mit der Haftfestigkeit zwischen den Schichten oder auf dem Substrat auftreten, und ohne dass sich z.B. durch ungewünschte Diffusionsvorgänge oder andere physikalisch chemische Reaktionen das erfindungsgemässe Schichtsystem mit der Zeit verschlechtert, oder bei hohen Temperaturen und grossen mechanischen Beanspruchungen im Betriebszustand versagt. Auch die aus dem Stand der Technik bekannten konventionellen Schicht wie z.B. Schichten aus den klassischen Verbindungen wie TiN, TiNC, CrN und andere sind vorteilhaft, je nach Anforderungen, mit einer erfindungsgemässen ersten Hartschicht kombinierbar.

Auch können die Teilschichten einer ersten Hartschicht mit der chemischen Zusammensetzung (AlₐMg_{b}Cr_{c}Me_{d}BₑAXₘSiₖ)G eines erfindungsgemässen Schichtsystems durch eine geeignete konkrete Auswahl des Al-, Mg- und Chromgehalts verschiedenste Funktionen übernehmen. So kann eine erfindungsgemässe (AlₐMg_{b}Cr_{c}Me_{d}BₑAXₘSiₖ)G -Schicht z.B. in einem Fall eine Haftschicht sein, die eine hervorragende Haftung des gesamten Schichtsystem auf dem Substrat herstellt, indem sie z.B. die Gitterparameter des Substrats an das weitere Schichtsystem anpasst, oder indem die spezielle Chemie des Substrats an diejenige des weiteren Schichtsystem angeglichen wird.

Eine erfindungsgemässe (AlₐMg_{b}Cr_{c}Me_{d}BₑAXₘSiₖ)G -Schicht kann aber auch z.B. in einer modifizierten chemischen Zusammensetzung in einem Schichtsystem eine Zwischenschicht mit den an sich bekannten Funktionen bilden oder aber auch eine deckende erste Hartschicht sein, die das Substrat, z.B. ein Werkzeug oder ein Verschleissteil, gegen thermische, mechanische und chemische Angriffe schützt.

In einem für die Praxis wichtigen Beispiel ist die Komponente AX ein Mischmetall.

Als besonders vorteilhaft zur Bildung eines Mischmetalls als Komponente AX hat sich dabei die Verwendung mindestens eines Seltene Erden Elements herausgestellt. Die Gruppe der Seltenen Erden umfasst dabei bekanntermassen die Lanthanoide, sowie Lanthan, Scandium und Yttrium. Dabei sind die reinen Elemente aus der Gruppe der Seltenen Erden zwar in bestimmten Eigenschaften durchaus verschieden, z.B. in Bezug auf die Schmelz- und Verdampfungspunkte, den Dampfdruck usw., jedoch sind sich diese Elemente in Bezug auf ihre chemischen Eigenschaften eher sehr ähnlich als verschieden, was sich allein schon darin zeigt, dass ihre Trennung in der Praxis sehr grosse Schwierigkeiten bereitet.

Daher kommen die Seltenen Erden häufig auch in Form von den erwähnten Mischmetallen zum Einsatz, d.h., es werden z.B. für Zulegierungen nicht reine Metalle aus der Gruppe der Seltenen Erden verwendet, sondern bestimmte Mischungen die zwei oder mehrere Elemente aus der Gruppe der Seltenen Erden und möglicherweise auch weitere andere chemische Elemente in vorgebbaren Mengen enthalten. Dabei ist es bekannt, dass bereits die Zugabe sehr kleiner Mengen von Mischmetallen, je nach Zusammensetzung, die chemischen und physikalischen Eigenschaften einer Grundsubstanz massiv beeinflussen kann.

Es hat sich dabei gezeigt hat, dass die Verwendung von Mischmetallen als Bestandteil der chemischen Komponente AX dazu führen kann, dass bereits geringste Mengen an Mischmetallen die gewünschten Eigenschaften eines erfindungsgemässen Schichtsystems enorm beeinflussen können, ohne dass entsprechende gravierende Änderungen z.B. in den chemischen Eigenschaften oder in der Gitterstruktur in Kauf genommen werden müssen. Dabei ist in der Literatur die Definition des "Mischmetalls" nicht ganz eindeutig. Im Rahmen der vorliegenden Anmeldung ist der Begriff des Mischmetalls jedenfalls in einer sehr breiten technischen Bedeutung zu verstehen.

In einer sehr engen Definition, die lediglich als spezielles Beispiel für ein bestimmtes Mischmetall zu verstehen ist und keinesfalls die Bedeutung des Begriffs Mischmetall für die vorliegende Anmeldung einschränkt, ist ein Mischmetall, auch Cer-Mischmetall, eine Metall-Legierung aus Metallen der Seltenen Erden. Es besteht z.B. zu 45% bis 52 % aus Cer, zu 20% bis 27 % aus Lanthan, zu 15% bis 18 % aus Neodym, zu 3% bis 5 % aus Praseodym, und zu 1% bis 3 % aus Samarium, Terbium und Yttrium, Spuren anderer Seltenerde-Metalle, Calcium und Silicium und bis zu 5 % aus Eisen.

Die Zusammensetzung kann sich beispielsweise unmittelbar aus der des Ausgangsminerals Monazit ergeben. Übersteigt der Eisenanteil 15 % (meist bis 50 %), spricht man häufig auch von Cer-Eisen.

Aufgrund der Ähnlichkeit der chemischen Eigenschaften der Seltenen Erden sind Abweichungen in der Zusammensetzung für bestimmte Eigenschaften unkritisch, während andere Eigenschaften sehr wohl durch eine Änderung der chemischen Zusammensetzung beeinflussbar sind.

Als Zusatz bei der Stahlherstellung können Mischmetalle unerwünschte Eisenoxide reduzieren, sie können Sauerstoff und Schwefel binden und die Entgasung unterstützen. Als Legierungsmetall können sie die Gieß- und Fließeigenschaften, sowie die Korrosionsbeständigkeit von Eisen-Chrom-Aluminium-Werkstoffen in heißen oxidierenden Gasen verbessern helfen.

Die folgende Tabelle 1 zeigt fünf weitere spezielle Beispiele von Mischmetallen, wobei die Definition des Begriffs "Mischmetall" für die Beispiele der Tabelle 1 deutlich weitergefasst ist. So umfassen die Mischmetalle der Tabelle 1 neben verschiedenen Seltenen Erden auch andere Beimischungen, und zwar sowohl Metalle, als auch Nichtmetalle wie Fe, Si, Mg, S, und Phosphor. Aber auch andere Elemente wie Hafnium (Hf), Kobalt (Co), Zirkon (Zr), Nickel (Ni) und weitere Elemente des Periodensystems können in einem Mischmetall vorhanden sein.

Aber wie bereits erwähnt, ist auch die Tabelle 1 für die Bedeutung des Begriffs Mischmetall im Rahmen dieser Anmeldung lediglich exemplarisch zu verstehen und wirkt in keiner Weise beschränkend für die Klasse der ganz verschiednen Mischmetalle, die in einem erfindungsgemässen Schichtsystem vorteilhaft von der Komponente AX umfasst sein können.

**Tabelle 1**

| | Mischmetall 1 | Mischmetall 2 | Mischmetall 3 | Mischmetall 4 | Mischmetall 5 |
|---|---|---|---|---|---|
| **La** | 25-33% | 25-34% | 25-34% | 30-40% | 44-50% |
| **Ce** | 48% min. | 48-55% | 48-55% | 60-70% | 50-56% |
| **Pr** | 4-7% | 4-6% | 4-6% | 0.5% max. | 0.1 % max. |
| **Nd** | 11-15% | 14-17% | 14-17% | 0.5% max. | 0.1% max. |
| **Fe** | 0.5% max. | 0.2% max. | 0.5% max. | 0.5% max. | 0.5% max. |
| **Si** | 0.2% max. | 0.05% max. | 0.2% max. | 0.2% max. | 0.2% max. |
| **Mg** | 0.5% max. | 0.05% max. | 0.5% max. | 0.5% max. | 0.5% max. |
| **S** | 0.02% max. | 0.02% max. | 0.02% max. | 0.02% max. | 0.02% max. |
| **P** | 0.01 % max. | 0.01 % max. | 0.01 % max. | 0.01 % max. | 0.01 % max. |

Vorteilhaft wird der Anteil von Aluminium (Al) im Bereich von 20 ≤ a ≤ 42, und der Anteil an Magnesium (Mg) im Bereich von 0.02 ≤ b ≤ 6 gewählt. Es hat sich insbesondere gezeigt, dass die Wahl des Al und Mg Anteils im vorgenannten Bereich zu einem guten Kompromiss bei der Optimierung von Oxidations- und Phasenbeständigkeit, bei gleichzeitiger Erhöhung von Härte, Druckeigenspannung und Zähigkeiten der Schichten führt, wobei darüber hinaus auch gute tribologische Eigenschaften erzielbar sind.

Die Metalle Me aus den Nebengruppen IVb und / oder Vb und / oder VIb sind bevorzugt in einer Menge entsprechend 4 ≤ d ≤ 54 in einer ersten Hartschicht vorhanden. Durch diese Wahl der Zusammensetzung lässt sich im Vergleich zu den aus dem Stand der Technik bekannten Hartschichten eine weitere Steigerung der Härte erreichen, wobei durch geeignete Wahl der konkreten Zusammensetzung der Metallgruppe Me, abhängig von der Anwendung der Beschichtung, eine Optimierung der Nitridbildung erreichbar ist.

Im Speziellen ist Si in einer Menge von höchstens k = 24 in der ersten Hartschicht vorhanden. Während Stickstoff (N) unter anderem wesentlich zur Härte des Schichtsystems beiträgt, und Silizium (Si) wesentlich für die Oxidationsbeständigkeit ist, führt die zusätzliche Verwendung von Bor (B) dazu, dass die Beständigkeit des Gefüges gegen thermische Belastungen wesentlich verbessert ist.

Durch die Einstellung des Siliziumgehalts auf den vorgenannten Bereich lässt sich z.B., aber nicht nur, gleichzeitig die Oxidationsbestaändigkeit und die Zähigkeit bzw. Härte der Schicht in bestimmten Grenzen weiter optimieren, bzw. zusätzlich zu anderen Massnahmen optimieren.

In ganz speziellen Fällen, wenn aus bestimmten Gründen z.B. die chemischen Elemente, die die Komponente AX bilden, eher kleinere Atomdurchmesser halben sollen, oder bestimmte chemische Randbedingungen zu erfüllen sind, kann die Komponente AX ausschliesslich nur aus Li und / oder aus Be und /oder aus Ca und / oder aus Si gebildet sein.

Dabei sind aus ähnlichen oder analogen oder anderen Gründen auch weitere Spezialfälle möglich. So kann AX in einem anderen Fall auch nur Sc und /oder nur Y und / oder nur La sein, oder AX kann nur mindestens ein Element aus der Gruppe der Lanthanoide ist, insbesondere nur Ce sein und sonst kein anderes Element umfassen.

Im Folgenden werden einige exemplarische Ausführungsbeispiele erfindungsgemässer Schichtsysteme diskutiert, die zur Bestimmung spezifischer Schichtparameter zunächst der Einfachheit halber als Einschichtsysteme der ersten Hartschicht hergestellt wurden. Es versteht sich, dass nicht nur die nachfolgenden Schichtsysteme sondern insbesondere alle im Rahmen dieser Anmeldung präsentierten Ausführungsbeispiele auch vorteilhaft kombinierbar sind.

In einem ersten Ausführungsbeispiel wurde eine AlCrMgSiN-Schicht untersucht. Dieses Ausführungsbeispiel soll das Verständnis der Erfindung erleichtern, ist aber nicht als erfindungsgemäss anzusehen.

Diese erste Hartschicht wurde in an sich bekannter Weise mittels einer Lichtbogenverdampfungsquelle in einer entsprechenden, dem Fachmann ebenfalls wohl bekannten Prozesskammer aufgebracht. Eine verwendete Lichtbogenverdampfungsquelle, oft auch einfach Kathode genannt, hat einen Durchmesser von 100 mm und bis auf technisch unwesentliche Verunreinigungen die folgende chemische Zusammensetzung: 68at-% Al, 29.5at-% Cr, 1.5%at-% Mg und 1at-% Si.

Die Zusammensetzung der aufgebrachten Schicht wurde sodann folgendermassen bestimmt:
REM: LEO, EDX: INCA, Beschleunigungsspannung 15keV.

Diese Untersuchung ergab die folgende Zusammensetzung der auf das Substrat aufgebrachten Schicht: 64.03at-% Al, 33.93at-%Cr, 1.08at-% Si und 0.96at-% Mg.
aufgeheizt, ionengereinigt und anschliessend bei einem Gasdruck von ungefähr 6.5Pa, bei einem Kathodenstrom von ca. 150A und einer Vorspannung von ca. 50V gepulst beschichtet.

Zum Vergleich wurde eine aus dem Stand der Technik bekannte AlTiN-Schicht hergestellt, wobei eine Kathode mit 55%-Atomprozent Al und 45%-Atomprozent Ti verwendet wurde.

Der notwendige Stickstoff wurde für beide Schichten über das Prozessgas in der Prozesskammer zur Verfügung gestellt.

Die folgende Tabelle 2 stellt die wichtigsten Schichteigenschaften der so erzeugten beiden Schichten vergleichend gegenüber.

**Tabelle 2**

| | AlTiN | AlCrMgSiN |
|---|---|---|
| Mikrohärte Knoop [HK0.025] | 2500 | 2850 |
| Verschleissrate [m²/(Nm)] | 2.9 | 1.9 |
| Oberflächenwiderstand [Ohm] | 10 | 27.250 |

Die Mikrohärte gemäss Tabelle 2 wurde dabei in bekannter Weise nach der Methode von Knoop bestimmt und die Verschleissrate über den Abrasionswiderstand mit einem KALOTEST mit kaloMAX NT der Firma BAQ mit einem Kugeldurchmesser von 30mm und 540 Wellenumdrehungen bei 60U/min unter Verwendung einer Schleifemulsion. Der Oberflächenwiderstand wurde mit einem Multimeter bei einem Abstand zwischen den Messspitzen von ca. 10mm gemessen.

Die Tabelle 2 demonstriert in beeindruckender Weise eine deutlich grössere Härte und eine um ca. 1/3 reduzierte Verschleissrate der erfindungsgemässen AlCrMgSiN -Schicht, im Vergleich zu der aus dem Stand der Technik bekannten AlTiN-Schicht. Bemerkenswert ist der enorm hohe Oberflächenwiderstand der erfindungsgemässen AlCrMgSiN-Schicht, der fast 3000 mal grösser, als derjenige der bekannten AlTiN-Schicht ist, was die erfindungsgemässe Schicht vor allem für Einsatzbereiche besonders interessant macht, in welchen unbedingt das Fliessen von Oberflächenströmen verhindert bzw. reduziert werden muss bzw. die Entstehung von magnetischen und elektrischen Feldern aufgrund von Oberflächenströmen unterdrückt bzw. verhindert werden muss. Somit ist die erfindungsgemässe Schicht insbesondere auch für Anwendungen besonders gut geeignet, wo entsprechende elektromagnetische, insbesondere dielektrische Eigenschaften der Schicht eine Rolle spielen.

In einem weiteren, für die Praxis sehr wichtigen Ausführungsbeispiel umfasst ein erfindungsgemässes Schichtsystem mindestens eine zusätzliche zweite Hartschicht der Zusammensetzung (MₖSiₗAₘ)G, mit (k+l+m) = 100, wobei G mindestens ein Element aus der Gruppe der chemischen Elemente bestehend aus N, C und O ist. M ist dabei mindestens ein Metall aus der Gruppe der chemischen Elemente bestehend aus: Al und den Elementen aus den Nebengruppen IVb, Vb, Vlb des Periodensystems der Elemente. Die Komponente A der zweiten Hartschicht ist mindestens ein Element aus der Gruppe der chemischen Elemente bestehend aus: Mn, Fe, Co, Ni, Cu, und den Elementen der Nebengruppe IIIb, und den Elementen der Hauptgruppe Ia, IIa, IIIa und den Elementen der Gruppe der Lanthanoide des Periodensystems der chemischen Elemente.

Das ist im wesentlichen identisch mit der Aussage, dass das Schichtsystem mindestens eine zusätzliche zweite Hartschicht der Zusammensetzung (MₒSiₚAY_{q})γ(NᵣCₛOₜ)δ, mit (o+p+q) = γ, (r+s+t) = δ, und (γ+δ) = 100, wobei 40 ≤ γ≤ 60 gilt, und wobei M mindestens ein Metall aus der Gruppe der chemischen Elemente bestehend aus Al und den Elementen aus den Nebengruppen IVb, Vb, Vlb des Periodensystems der Elemente ist. Die Komponente AY ist mindestens ein Element aus der Gruppe der chemischen Elemente bestehend aus Mn, Fe, Co, Ni, Cu und den Elementen der Nebengruppe IIIB und den Elementen der Hauptgruppe IA, IIA und IIIA und den Elementen der Gruppe der Lanthanoide des Periodensystems der chemischen Elemente.

Wobei zur besseren Unterscheidung das Symbol A in der Formeleinheit (MₖSi_{|}Aₘ) durch das Symbol AY in der Formeleinheit (MₒSiₚAY_{q})γ ersetzt wurde.

Eine gegenüber dem Stand der Technik weitere erheblich verbesserte Leistungsfähigkeit der Werkzeuge und Bauteile wird somit dadurch erreicht, dass die entsprechenden Substrate mit einer zusätzlichen zweiten Hartschicht der Zusammensetzung (MₖSiⱼAₘ)G, genauer (MₒSiₚAY_{q})γ(NᵣCₛOₜ)δ beschichtet werden, wobei G somit in an sich bekannter Zusammensetzung mindestens ein Element aus der Gruppe Stickstoff (N), Kohlenstoff (C) und Sauerstoff (0) ist, also G zum Beispiel die chemische Struktur (NᵣCₛOₜ)δ hat, und M mindestens ein Metall aus der Gruppe der chemischen Elemente bestehend aus Aluminium (Al) und den Elementen aus den Nebengruppen IVb, Vb, Vlb des Periodensystems der Elemente ist.

Die nochmals deutlich verbesserten Eigenschaften eines erfindungsgemässen Schichtsystems mit einer zweiten Hartschicht, vor allem in Bezug auf Härte, Druckeigenspannungen Oxidationsfestigkeit und Phasenstabilität bis hinauf zu Temperaturen von 1.200°C und mehr, konnten dadurch erreicht werden, dass die Komponente AY die chemische Zusammensetzung der zweiten Hartschicht ergänzt, wobei AY mindestens ein Element aus der Gruppe der chemischen Elemente bestehend aus Mangan (Mn), Eisen (Fe), Kobalt (Co), Nickel (Ni), Kupfer (Cu), und den Elementen der Nebengruppe IIIB, und den Elementen der Hauptgruppe IA, IIA, IIIA und den Elementen der Gruppe der Lanthanoide des Periodensystems der chemischen Elemente ergänzt wird. Bekanntermassen besteht dabei die Hauptgruppe IIIa des Periodensystems der Elemente, aus den Elementen Bor (B), Aluminium (Al), Gallium (Ga), Indium (In) und Thallium (TI).

Als besonders vorteilhaft hat sich für die Komponente AY der zweiten Hartschicht die Verwendung mindestens eines Seltene Erden Elements herausgestellt. Dabei hat sich herausgestellt, dass bereits die Zugabe sehr kleiner Mengen von Mischmetallen, je nach Zusammensetzung, auch die chemischen und physikalischen Eigenschaften einer zweiten (MₖSiₗAₘ)G-Hartschicht massiv beeinflussen können.

Überraschender Weise hat sich darüber hinaus gezeigt, dass sich ein erfindungsgemässes Schichtsystem, durch die Zugabe der Komponente AY der zweiten Hartschicht in Form einer oder mehrerer Seltene Erden Elemente und / oder eines oder mehrerer Elemente der Hauptgruppe IA, und / oder IIA und / oder IIIA diese Eigenschaften entscheidend verbessern lassen, wobei es durch geeignete Wahl der chemischen Zusammensetzungen durch die vorliegende Erfindung erstmals gelungen ist, Oxidationsbeständigkeit, Phasenbeständigkeit, Härte und andere entscheidende Grössen, wie z.B. die Haftfestigkeit und Druckeigenspannungen noch weiter verbessern und zu optimieren.

Insbesondere hat sich auch gezeigt, dass sich auch die Schichten vom Typ der zweiten Hartschicht vorteilhaft mit bereits bekannten Schichten und Schichtsystemen zu neuen Schichtsystemen kombinieren lassen, so dass durch die vorliegende Erfindung völlig neue Schichtsysteme mit im Vergleich zum Stand der Technik in fast jeder Hinsicht verbesserten Eigenschaften bereitgestellt werden.

Das liegt insbesondere daran, dass durch eine geeignete Auswahl der chemischen Elemente, die die Komponente AY in dem erfindunsgemässen Schichtsystem (MₖSiₗAₘ)G, also (MₒSiₚAY_{q})γ(NᵣCₛOₜ)δ bildet, die Schichtsysteme der vorliegenden Erfindung eine enorme Flexibilität erreichen, da z.B. für die Komponente AY der zweiten Hartschicht eine breite Auswahl an Atomdurchmessern zur Verfügung steh, wodurch z.B. Gitterparameter angepasst werden können, ohne dabei die chemischen Bindungsmöglichkeiten negativ zu beeinflussen.

Auch können die Teilschichten umfassend eine zweite Teilschicht mit der chemischen Zusammensetzung (MₒSiₚAY_{q})γ(NᵣCₛOₜ)δ eines erfindungsgemässen Schichtsystems durch geeignete Auswahl der chemischen Zusammensetzung der Komponente AY verschiedenste Funktionen übernehmen. So kann eine zweite (MₒSiₚAY_{q})γ(NᵣCₛOₜ)δ-Hartschicht z.B. in einem Fall eine Haftschicht sein, die eine hervorragende Haftung des gesamten Schichtsystem auf dem Substrat herstellt, indem sie z.B. die Gitterparameter des Substrats an das weitere Schichtsystem anpasst, oder indem die spezielle Chemie des Substrats an diejenige des weiteren Schichtsystem angeglichen wird.

Eine zweite (MₒSiₚAY_{q})_{γ}(NᵣCₛOₜ)_{δ}-Hartschicht kann aber auch z.B. in einer modifizierten chemischen Zusammensetzung in einem Schichtsystem eine Zwischenschicht mit den an sich bekannten Funktionen bilden oder aber auch eine deckende erste Hartschicht sein, die das Substrat, z.B. ein Werkzeug oder ein Verschleissteil, gegen thermische, mechanische und chemische Angriffe schützt.

Bei einem bevorzugten Ausführungsbeispiel kann die Komponente A der zweiten Hartschicht zusätzlich noch Bor (B) enthalten. Während Stickstoff (N) unter anderem wesentlich zur Härte des Schichtsystems beiträgt, und Silizium (Si) wesentlich für die Oxidationsbeständigkeit ist, kann durch die zusätzliche Verwendung von B die Beständigkeit des Gefüges gegen thermische Belastungen noch weiter wesentlich verbessert werden.

Bevorzugt, aber nicht notwendig, ist der Anteil von Si in der zweiten Hartschicht auf einen Bereich von 0.04 ≤ p < 30 eingestellt.

Durch die Einstellung des Siliziumgehalts auf den vorgenannten Bereich lässt sich z.B., aber nicht nur, gleichzeitig die Oxidationsbeständigkeit und die Zähigkeit bzw. Härte sowie die Druckeigenspannungen der zweiten Hartschicht und damit des gesamten erfindungsgemässen Schichtsystems in vorgebbaren Grenzen optimieren, bzw. zusätzlich zu anderen Massnahmen optimieren.

Der Anteil der chemischen Komponente AY in der Formeleinheit (MₒSiₚAY_{q})γ(NᵣCₛOₜ)δ der zweiten Hartschicht liegt dabei bevorzugt im Bereich 0.004 < q < 6 ist, wobei, wie bereits erwähnt natürlich auch diese Angaben als Atomprozent zu verstehen sind.

Durch die Wahl der Komponente AY einer zweiten Hartschicht im vorgenannten Bereich lassen sich, wie sich gezeigt hat, neben weiteren Parametern, die Phasenbeständigkeit auch bei sehr hohen Temperaturen, selbst oberhalb von 1200°C eines erfindungsgemässen Schichtsystems weiter verbessern, aber auch die Oxidationsbeständigkeit lässt sich dadurch noch weiter erhöhen, wobei gleichzeitig relevante Gitterparameter angepasst werden können, so dass ein gewünschtes Eigenspannungsniveau des Schichtsystems einstellbar ist und darüber hinaus die Härte des Schichtsystem weiter erhöhbar ist.

Wie bereits erwähnt, ist die Komponente AY der zweiten Hartschicht bevorzugt, jedoch nicht notwendig, ein Element aus der Gruppe der Seltenen Erden, insbesondere ein Element aus der Gruppe der chemischen Elemente bestehend aus Y und den Lanthanoiden, insbesondere Ce und / oder La, was die weiter oben bereits ausführlich beschrieben Vorteile des erfindungsgemässen Schichtsystems bewirkt.

Wie bereits erwähnt kann die Komponente AY der zweiten Hartschicht auch ein Mischmetall umfassen, wobei sich gezeigt hat, dass die Verwendung von Mischmetallen als Bestandteil der chemischen Komponente AY dazu führen kann, dass bereits geringste Mengen an Mischmetallen die gewünschten Eigenschaften eines erfindungsgemässen Schichtsystems enorm beeinflussen können, ohne dass entsprechende gravierende Änderungen, z.B. in der chemischen Zusammensetzung oder in der Gitterstruktur in Kauf genommen werden müssen.

In ganz speziellen Fällen, wenn aus bestimmten Gründen z.B. die chemischen Elemente, die die Komponente AY der zweiten Hartschicht bilden, eher kleinere Atomdurchmesser haben sollen, oder bestimmte chemische und / oder physikalische Randbedingungen zu erfüllen sind, kann die Komponente A ausschliesslich nur aus Be und / oder nur aus Ca gebildet sein.

Dabei sind aus analogen oder ähnlichen oder anderen Gründen auch weitere Spezialfälle möglich. So kann die Komponente AY der zweiten Hartschicht in einem anderen Fall auch nur Sc und / oder Y und / oder La sein, und / oder AY kann nur mindestens ein Element aus der Gruppe der Lanthanoide sein, insbesondere nur Ce sein und sonst kein anderes Element umfassen.

Im Folgenden werden einige exemplarische Ausführungsbeispiele erfindungsgemässer Schichtsysteme mit einer zweiten Hartschicht diskutiert, wobei zur Bestimmung spezifischer Schichtparameter zunächst der Einfachheit halber nur Einschichtsysteme einer zweiten Hartschicht hergestellt wurden. Es versteht sich, dass nicht nur die nachfolgenden Schichtsysteme sondern insbesondere alle im Rahmen dieser Anmeldung präsentierten Ausführungsbeispiele auch vielfältig vorteilhaft kombinierbar sind.

Im folgenden wird eine zweite TiSiN-Hartschicht diskutiert, die in einem erfindungsgemässen Ausführungsbeispiel einen Anteil eines Cer-Mischmetalls enthält. Die Schicht wurde in an sich bekannter Weise mittels einer Lichtbogenverdampfungsquelle in einer entsprechenden, dem Fachmann ebenfalls wohl bekannten Prozesskammer aufgebracht. Eine verwendete Lichtbogenverdampfungsquelle, oft auch einfach Kathode genannt, hat im vorliegenden Beispiel einen Durchmesser von 100mm und bis auf technisch unwesentliche Verunreinigungen die folgende chemische Zusammensetzung: 82.5at-% Ti, 17%at-% Si, 0.5%at-% Cer-Mischmetall (Ce_{M}), wobei das Cer-Mischmetall zu 54%-Gewichtsprozent aus Ce, zu 29%-Gewichtsprozent aus La, zu 13%- Gewichtsprozent aus Nd und zu 4%-Gewichtsprozent aus Pr besteht.

Zur Beschichtung wurde ein Substrat, im vorliegenden Fall ein Schnellarbeitsstahl, in der Prozesskammer zunächst auf ca. 500°C aufgeheizt, ionengereinigt und anschliessend bei einem Gasdruck von ungefähr 5Pa, bei einem Kathodenstrom von ca. 130A und einer Vorspannung von ca. 50V beschichtet.

Zum Vergleich wurde unter den gleichen Beschichtungsbedingungen eine aus dem Stand der Technik bekannte AlTiN-Schicht hergestellt, wobei eine Kathode mit 55%-Atomprozent Al und 45%-Atomprozent Ti verwendet wurde. Der notwendige Stickstoff wurde für beide Schichten über das Prozessgas in der Prozesskammer zur Verfügung gestellt.

Die folgende Tabelle 2 stellt die wichtigsten Schichteigenschaften der so erzeugten beiden Schichten vergleichend gegenüber. Dabei bedeutet in Tabelle 3 Ce_{M} ein wie zuvor definiertes Cer-Mischmetall.

**Tabelle 3**

| | AlTiN | TiSiCe_{M}N |
|---|---|---|
| Mikrohärte Knoop [HK0.025] | 2226 | 4093 |
| Verschleissrate | 8.09 | 3.59 |
| [m²/(Nm)] | | |

Die Mikrohärte gemäss Tabelle 3 wurde dabei in bekannter Weise nach der Methode von Knoop bestimmt und die Verschleissrate über den Abrasionswiderstand mit einem KALOTEST N Gerät der Firma BAQ mit einem Kugeldurchmesser von 30mm und 540 Wellenumdrehungen bei 60U/min unter Verwendung einer Schleifemulsion.

Die Tabelle 3 demonstriert in beeindruckender Weise eine fast doppelt so grosse Härte und eine weniger als halb so grosse Verschleissrate der erfindungsgemässen TiSiCe_{M}N-Schicht, im Vergleich zu der aus dem Stand der Technik bekannten AlTiN-Schicht.

In Röntgenbeugungsuntersuchungen konnte dabei bei den erfindungsgemässen Schichten eine eindeutig bevorzugte (200)-Orientierung des Gitters beobachtet werden, während (111)-Orientierungen praktisch nicht zu beobachten waren.

Wie bereits erwähnt, kann in einem bevorzugten Ausführungsbeispiel eines erfindungsgemässen Schichtsystems die erste Hartschicht eine abschliessende Deckschicht des Schichtsystems sein, während in einem anderen Ausführungsbeispiel die zweite Hartschicht eine abschliessende Deckschicht des Schichtsystems bildet.

Im speziellen kann ein erfindungsgemässes Schichtsystem eine Funktionsschicht, insbesondere eine Verbundschicht, bevorzugt eine Verbundschicht aus MetₓE_{y}N_{z}, mit x > 0; y ≥ 0 und z > 0 umfassen, wobei Met mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

Dabei kann z.B. eine Zwischenschicht umfassend die Elemente Si und / oder C vorgesehen sein und / oder es ist eine Gradienten-Mischschicht vorgesehen, die die Elemente Si und / oder C der Zwischenschicht und die Zusammensetzung (AlₐMg_{b}Cr_{c}Me_{d}BₑAXₘSiₖ)_{α}(NᵤCᵥO_{w})_{β} der ersten Hartschicht und / oder die Zusammensetzung (MₒSiₚAY_{q})_{γ}(NᵣCₛOₜ)_{δ} der zweiten Hartschicht umfasst.

Im speziellen kann in der Funktionsschicht der Anteil der metallischen Komponenten der Schicht minimiert sein bzw. ganz fehlen, so dass als Funktionsschicht Si/B dominierende Schichten zusätzlich in einem erfindungsgemässen Schichtsystem vorgesehen sind.

Bedingt durch die komplizierte Herstellung ist dabei zu SiBx Keramiken bisher noch relativ wenig bekannt. Es liegen zum Beispiel folgende Angaben für SiB₆ Volumenmaterialien vor orthorhombisches Gitter, Härte ca. 2600 , Elastizitätsmodul 290 GPa, Dichte 2,43 g/cm³, thermischer Ausdehnungskoeffizient 4,6 *10⁻⁶/ °C, Wärmeleitfähigkeit 9 W/mK, Schmelzpunkt 1950 °C. Insbesondere ist die hohe Oxidationsbeständigkeit hervorzuheben: stabil in Luft bis 1550 °C.

Diese Stabilität von SiBx Keramiken bei hohen Temperaturen wird von den klassischen Schichtsystemen wie AlTiN, AlCrSiN und TiSiN nicht erreicht. Dabei sind solche Volumeneigenschaften in ähnlicher Form bei Schichten des Typs SiBx hinsichtliche der Härten und der Oxidationseigenschaften zu finden, wobei die Darstellung dieser Schichten mittels der PVD-Beschichtung industrielle Relevanz hat.

Der Mechanismus des Oxidationsschutzes der SiBx-Funktionsschichten beruht dabei auf der Ausbildung einer Doppelschicht des Types SiO/BO. Die entstehende äußere Si-reiche Schicht verhindert die Sauerstoffdiffusion in die Schicht.

Es wurde daher bereits vorgeschlagen, die neue Beschichtungs-Materialklasse SiBx, insbesondere speziell die neue Beschichtungs-Materialklasse SiBCN als Beschichtungsmaterial für Werkzeuge einzusetzen. Insbesondere weil sich gezeigt hat, dass eine Funktionsschicht auf der Basis von SiB-Verbindungen, bzw. von SiBNC in Kombination mit den bekannten klassischen Hartstoffschichten ebenfalls zu den deutlich verbesserten Schichteigenschaften führt, wird mit der vorliegenden Erfindung vorgeschlagen, derartige Funktionsschichten, falls notwendig, ebenfalls in ein Schichtsystem der vorliegenden Erfindung zu integrieren.

Je nach Anforderung an die zu beschichtenden Substrate bzw. Werkzeuge kann es im Speziellen besonders vorteilhaft sein, die Funktionsschichten in einem erfindungsgemässen Schichtsystem mit Sauerstoff zu dotieren, und so zum Beispiel zu SiBNCO-Schichten zu gelangen, die unter anderem durch Voroxidation bzw. durch Verfeinerung der Struktur der Schichten die Diffusion von Sauerstoff reduzieren und die Oxidationsbeständigkeit auch bei hohen Temperaturen massiv erhöhen.

Die Dotierung mit Sauerstoff der Funktionsschicht führt darüber hinaus zu einer Belegung der Korngrenzen mit Sauerstoff, so dass zumindest bei einer partiellen Ausbildung der oben genannten oder anderer

Doppelschichtsysteme die Neigung zu Strukturumwandlung in den Schichtsystemen, die oftmals eine mehr oder weniger offene Porosität bzw. Schichtdefekte aufweisen, reduziert wird, da durch die Dotierung mit Sauerstoff eine Voroxidation eingeleitet wird.

Gemäss der vorliegenden Erfindung ist es dabei entscheidend, dass die Funktionsschichten mindestens die beiden Elemente Si und B aufweisen, insbesondere damit sich schützende Doppelschichten ausbilden können. Das heisst, ein erfindungsgemässes Schichtsystem kann mindestens eine Funktionsschicht der Zusammensetzung SiₐB_{b}Me_{c}NᵤCᵥO_{w} mit a,b > 0 und 33at-% > c ≥ 0 und u,v,w ≥ 0, wobei Me ein Metall ist, dass im Speziellen z.B. ein für die Targetherstellung zur Abscheidung der erfindungsgemäßen Schicht verwendetes Metall z.B. Al bei SiC, oder aber ein gezielt eingebautes metallisches Element sein kann.

Die Funktionsschichten eines erfindungsgemässen Schichtsystems können dabei vorzugsweise auf geeigneten metallischen Zwischenschichten aber auch auf Si, SiC Zwischenschichten, sowie auf einer ersten Hartschicht oder auf einer zweiten Hartschicht gemäss der vorliegenden Erfindung abgeschieden werden, sowie direkt auf metallischen oder keramischen Werkzeugmaterialien oder vorzugsweise auf mit Hartstoffschichten beschichteten Werkzeugmaterialien abgeschieden werden.

Bevorzugt, aber nicht notwendig, liegen die Funktionsschichten eines erfindungsgemässen Schichtsystems in einem weitgehend amorphen Zustand vor, wobei in einem speziellen Ausführungsbeispiel eine Ausbildung von nanokristallinen Bereichen in den Funktionsschichten vorliegen kann.

Die Schichtdicken der Funktionsschichten liegen dabei im Bereich zwischen ca. 5 nm - 50 000 nm, im Speziellen zwischen 10 nm und 2500 nm, vorzugsweise zwischen (100 - 500) nm und können als Unterschicht z.B. Al-Basishartstoffschichten abgeschieden in gleichen oder in getrennten Anlagen umfassen.

Die metallische Komponente Me einer Funktionsschicht ist dabei mindestens ein Metall aus der Gruppe AI, Cr, Mo, W, V,Nb, Ta, Ti, Zr, HF, Mn, Fe; Co; Ni, Li, Be, Mg, Sc, Y, La, Ce, Nd, Sm.

Bei einem besonders bevorzugten Ausführungsbeispiel ist auf der Oberfläche des Substrats mindestens eine Verbundschicht, bevorzugt eine Verbundschicht aus MeₓE_{y}N_{z}, mit x,y ≥ 0 und z > 0 vorgesehen, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm und E ein Element aus der Gruppe bestehend aus Si, B, C, O ist.

Für spezielle Anwendungen kann ein spezielles erfindungsgemässes Schichtsystem auch eine Zusatzhartschicht aus SiₐB_{b}Me_{c}NᵤCᵥO_{w}, insbesondere eine Zusatzhartschicht aus SiₐB_{b}Me_{c}CᵥNᵤ, im speziellen eine Zusatzhartschicht aus SiₐB_{b}CᵥNᵤ vorgesehen sein.

In einem besonders bevorzugten Ausführungsbeispiel ist eine AlTi-Hartschicht mit der Zusammensetzung (Al_{1-α-β}Ti_{α}X_{β}) (N_{1-γ}C_{γ}O_{δ}B_{ε}), mit 0.2 < α < 0.6, 0 ≤ β < 0.2 und α+β > 0.01 und 0 ≤ γ < 0.5, 0 ≤ δ < 0.5, 0 ≤ε < 0.5 und γ+δ+ε > 0.01, wobei X ein Element der Gruppe bestehend aus Zr, V, Cr, Nb, Ta; W; Mo; Hf, Mg Si, Y ist.

Die Funktionsschichten auf der Basis von SiB werden im Bereich der atomaren Zusammensetzung von Si:B im Bereich von 9 bis 0.1 abgeschieden, wobei die verschiedensten Zusammensetzungen innerhalb einer Gradientenschicht bzw. mehrlagigen Schicht darstellbar sind. Bevorzugt werden Bor-reiche Funktionsschichen abgeschieden, d. h: der Si Gehalt ist kleiner als der Borgehalt. Insbesondere ist die Zusammensetzung mit 6 Boaratomen pro Si-Atom interessant, da sich zumindest lokal die besonders stabile SiB6-Struktur in den Funktionsschichten ausbilden kann.

Die Zuführung von N,C;O führt zur Ausbildung verschiedenster Bindungszustände in den Funktionsschichten, so treten B-N, B-C, Si-N ,Si-C, Si-O, B-O Bindungen auf, die sich jedoch nur aufwendig quantifizieren lassen. Die kovalenten Bindungsanteile (z.B SiN und BC) bewirken eine hohe Härte. Der strukturelle Mechanismus und der Bindungsmechanismus dieser komplexen Schichten ist beim gegenwärtigen Stand des Wissens nur unzureichend, um Voraussagen über die komplexen Schichteigenschaften zu treffen.

In einer bevorzugten Ausführungsform sollte die atomare Zusammensetzung der Funktionsschichtenten im Verhältnis aus ca. gleichen Anteilen von Si und Bor und N bzw. Mischungen aus N,C,O bestehen. Es ist aber auch eine überstöchiometrische Zusammensetzung hinsichtlich des N und C-Gehaltes bezogen auf SiB anstrebenswert, die jedoch herstelltechnisch problematisch ist. Beispielsweise wäre eine solche Schichtzusammensetzung ca. gleiche Anteile von Si, B und C jedoch ca. einen N-Anteil, der das dreifache des Si-Anteiles beträgt entsprechend der Volumenkeramiken sinnvoll.

Bei den oben beschriebenen bevorzugten Zusammensetzungen der Funktionsschichten können sich zumindest lokal hochstabile Verbindungen ausbilden - in Form von Si₃B₃N₇ oder SiBN₃C.

Die Sauerstoffgehalte in den Funktionsschichten werden deutlich unter 50 at-% vorzugsweise um 10 at-% bezogen auf die Gesamtzusammensetzung begrenzt, da der ionische Bindungsanteil, der in der Regel zu sprödem Materialverhalten führt begrenzt werden sollte.

Metallanteile in den Funktionsschichten werden sinnvoll ebenfalls mit deutlich unter 50 at-% eingestellt, wobei diese meist - außer in den Zwischenschichten - auf maximal 10 at-% beschränkt sind. Diese Anteile dienen dabei als Bindungsbrücken zur untereren Hartstoffschicht bzw. entstammen aus den Targetbindemitteln.

Die Härten der Funktionsschichten überstreichen dabei den Bereich von ca. 1000 bis 5000 Vickers, bevorzugt zwischen 2000 und 3500 Vickers. Die Auswahl der geeigneten Schicht richtet sich dabei nach den jeweiligen tribologischen Eigenschaften. Beispielsweise ist für verschiedene Mikrowerkzeuge die Reibung aussschlagebend, um Überhitzungen zu vermeiden, so dass reibungsmindernde Boroxide wünschenswert sind, wobei schon Schichthärten um 1000 Vickers sinnvoll sein können. Es kommt auf eine tribologische Trennschicht an. In Anwesenheit von Luftfeuchtigkeit wandelt sich das Boroxid zu Borsäure um, wodurch niedrige Reibwerte erreichbar sind.

Bei Kugelfräsern im Kontakt zu Ti-Legierungen sollte hingegen ein hohes Härteniveau eingestellt werden.

Nicht nur, aber auch zur Verbesserung der Hafteigenschaften auf dem Substrat bzw. auf einer anderen Schicht des erfindungsgemässen Schichtsystems, zum Beispiel auf einem besonders stark beanspruchten Werkzeug, kann eine Zwischenschicht umfassend die Elemente Si und / oder C vorgesehen sein.

Darüber hinaus kann in einem weiteren Ausführungsbeispiel eine Gradienten-Mischschicht vorgesehen sein, die die Elemente Si und / oder C der Zwischenschicht und die Zusammensetzung SiₐB_{b}Me_{c}NᵤCᵥO_{w}, insbesondere SiₐB_{b}Me_{c}CᵥNᵤ, im speziellen SiₐB_{b}CᵥNᵤ der ersten Hartschicht umfasst. Die Zusammensetzung der Gradienten-Mischschicht kann sich dabei mehr oder weniger kontinuierlich von der Zusammensetzung einer ersten Schicht, mit der die Gradienten-Mischschicht in Kontakt ist, zu der Zusammensetzung einer zweiten Schicht, mit der die Gradienten-Mischschicht ebenfalls in Kontakt ist, ändern, so dass die erste und die zweite Schicht, die zum Beispiel verschiedene chemische und / oder physikalische Eigenschaften, wie Gitterstruktur, Kristallinität, thermische Ausdehnung usw. haben können, optimal aufeinander anpassbar.

Besonders vorteilhaft ist eine Sauerstoff-Funktionsschicht aus SiₐB_{b}MeNᵤCᵥO_{w}, im speziellen eine SiₐB_{b}NᵤCᵥO_{w} Sauerstoff-Funktionsschicht vorgesehen, die insbesondere als Deckschicht vorgesehen sein kann. Diese Deckschicht kann zum Beispiel, aber nicht nur die Diffusion von Sauerstoff in die Schicht unterbinden oder minimieren, dadurch unter anderem die Oxidationsfestigkeit erhöhen. Ausserdem kann die Deckschicht dem Schichtsystem gegen Angriffe von aussen, besondere chemische, thermische und mechanische Eigenschaften verleihen, so dass das erfindungsgemässe Schichtsystem durch die Deckschicht zum Beispiel besonders gut gegen die hohe Temperatur geschützt ist und / oder besonders vorteilhafte mechanische Eigenschaften, oder besonders gute tribologische Eigenschaften aufweisen.

Es versteht sich, dass die zuvor beschriebenen Ausführungsbeispiele der Erfindung, je nach Anwendung, auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen

Es versteht sich, dass die zuvor beschriebenen Ausführungsbeispiele der Erfindung, je nach Anwendung, auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen Schichtsystems ganz fehlen können oder in einem anderen Ausführungsbeispiel in ein und demselben Schichtsystem auch mehrfach vorkommen können.

Im Speziellen kann dabei eine Schichtdicke der Verbundschicht und / oder der Zwischenschicht und / oder der ersten Hartschicht und / oder der zweiten Hartschicht und / oder der Gradienten-Mischschicht zwischen 0.1 µm und
50 µm, insbesondere zwischen 1 µm und 15 µm, vorzugsweise zwischen 5 µm und 8 µm liegt.

Eine Härte HK0.05 der ersten Hartschicht und / oder der zweiten Hartschicht liegt bevorzugt zwischen 10 GPa und 50 GPA, insbesondere zwischen 25 GPa und 35 GPa und eine Druckeigenspannung der ersten Hartschicht und / oder der zweiten Hartschicht liegt zwischen 0.1 GPa und 10 GPA, insbesondere zwischen 1.5 GPa und 4 GPa.

Eine Oxidationsbeständigkeit und / oder eine Phasenstabilität eines erfindungsgemässen Schichtsystems ist dabei bis zu Temperaturen grösser als 700°C, insbesondere bis zu Temperaturen grösser als 1.000°C gewährleistet.

Zum Aufbringen eines erfindungsgemässen Schichtsystems betrifft die Erfindung weiterhin eine erste Lichtbogenverdampfungsquelle mit einem Verdampfungsmaterial als Kathode zur Erzeugung einer Oberflächenschicht auf einer Oberfläche eines Substrats durch Verdampfung des Verdampfungsmaterials mittels einer Lichtbogenentladung auf einer Verdampfungsoberfläche der Kathode. Dabei hat das Verdampfungsmaterial eine chemische Zußammensetzung (Al_{a'}Mg_{b'}Cr_{c'}Me_{d'}B_{e'}A_{m'}Si_{k'}), mit (a'+b'+c'+d'+e'+m'+k') = 100, und wobei Me mindestens ein Element aus der Gruppe der chemischen Elemente bestehend aus den Nebengruppen IVb, Vb und VIb des Periodensystems der chemischen Elemente ist. A ist mindestens ein Element aus der Gruppe der chemischen Elemente bestehend aus den Elementen der Hauptgruppen Ia, IIa und den Elementen der Nebengruppen VIIb, VIIIb, Ib, IIb, IIIb und den Elementen der Gruppe der Lanthanoide des Periodensystems der Elemente, wobei 0.01 ≤ m' < 100, bevorzgt 0.012≤ m'≤ 80 ist. Erfindunggemäss ist dabei der Gehalt an Al, Mg und Cr auf 1 ≤ a ≤ < 97 und 0.1 ≤ b ≤ 20 bzw. 30 ≤ c ≤ 70 beschränkt.

In einem speziellen Ausführungsbeispiel enthält die Lichtbogenverdampfungsquelle zusätzlich C und / oder N und / oder O, wobei in einem für die Praxis besonders wichtigen Ausführungsbeispiel die Komponente A ein Mischmetall sein kann.

Im Speziellen liegt der Aluminiumgehalt im Bereich 50 ≤ a' ≤ < 70 ist und der Magnesiumgehalt ist auf einen Bereich 0.5 ≤ b' ≤ 10 beschränkt.

Bevorzugt, aber nicht notwendig, ist Me in einer Menge entsprechend 10 ≤ d' ≤ 80 in der Lichtbogenverdampfungsquelle vorhanden, und der Gehalt an Si beträgt höchstens k' = 40 in einer Kathode der vorliegenden Erfindung. Im Speziellen ist die Komponente A nur Li und / oder Be und / oder Ca und /oder Si, und / oder A ist nur Sc und / oder Y und / oder La, wobei in einem anderen Ausführungsbeispiel A nur mindestens ein Element aus der Gruppe der Lanthanoide ist, insbesondere nur Ce ist.

Die Erfindung betrifft weiterhin eine Kombinations Verdampfungsquelle. Eine zweite Lichtbogenverdampfungsquelle betrifft eine Quelle mit einem Verdampfungsmaterial als Kathode zur Erzeugung einer Oberflächenschicht auf einer Oberfläche eines Substrats durch Verdampfung des Verdampfungsmaterials mittels einer Lichtbogenentladung auf einer Verdampfungsoberfläche der Kathode, wobei das Verdampfungsmaterial eine chemische Zusammensetzung (MₖSiₗAₘ)G ist, mit (k+l+m) = 100, geanuer gesagt mit (M_{o'}Si_{p'}AY_{q'}) ist, mit (o'+p'+q') = 100, und wobei M mindestens ein Metall aus der Gruppe der chemischen Elemente bestehend aus Al und den Elementen aus den Nebengruppen IVb, Vb, VIb des Periodensystems der Elemente ist. Die Komponente A der zweiten Lichtbogenverdampfungsquelle A ist dabei mindestens ein Element aus der Gruppe der chemischen Elemente bestehend aus Mn, Fe, Co, Ni, Cu, und den Elementen der Nebengruppe IIIB, und den Elementen der Hauptgruppe IA, IIA und IIIA, und den Elementen der Gruppe der Lanthanoide des Periodensystems der chemischen Elemente.

In einem bevorzugten Ausführungsbeispiel kann die zweite Lichtbogenverdampfungsquelle zusätzlich C und / oder N und / oder O enthalten und / oder die Komponente A enthält zusätzlich Bor (B).

AY ist ein Element aus der Gruppe der chemischen Elemente bestehend aus Y und den Lanthanoiden, insbesondere Ce und / oder La ist.

Im speziellen kann die Komponente AY der zweiten Verdampfungsquelle nur Be und / oder Ca sein und / oder AY kann in einem anderen Ausführungsbeispiel nur Sc und / oder Y und / oder La sein.

In einem speziellen aber wichtigen Fall ist AY nur mindestens ein Element aus der Gruppe der Lanthanoide, insbesondere kann die Komponente AY nur aus Ce bestehen.

Darüber hinaus betrifft die Erfindung auch Kombinations-Verdampfungsquelle mit einem Verdampfungsmaterial bestehend aus einem Verdampfungsmaterial der ersten Verdampfungsquelle und der zweiten Verdampfungsquelle.

Schliesslich betrifft die Erfindung auch ein Substrat, insbesondere eine Werkzeug, das mit einem Schichtsystem gemäss der vorliegenden Erfindung beschichtet ist.

Ein erfindungsgemässes Werkzeug kann dabei ein Urformwerkzeug, ein Presswerkzeug, ein spanendes Werkzeug, insbesondere ein Bohrer, ein Fräser, eine Wendeschneidplatte für einen Dreh- oder Fräsprozess oder ein Hobelwerkzeug, ein Umformwerkzeug oder ein Mikrowerkzeug, insbesondere ein Mikrobohrer, eine Mikrowendeschneidplatte, ein Mikrofräser oder ein anderes Werkzeug oder Mikrowerkzeug oder ein Kunststoffwerkzeug sein.

Ein erfindungsgemäss beschichtetes Substrat kann darüber hinaus auch ein Verschleissteil, insbesondere ein Verschleissteil für eine Luft- oder Land gestützte Turbine, einen Motor, im Speziellen für einen Verbrennungsmotor, im speziellen eine Dichtung, ein Zahnrad, ein Kolben ein Kolbenring, ein Verschleissteil für eine Textilmaschine oder ein anderes Verschleissteil ist.

## Patentansprüche

1. Schichtsystem zur Bildung einer Oberflächenschicht auf einer Oberfläche eines Substrats, insbesondere auf der Oberfläche eines Werkzeugs, wobei das Schichtsystem mindestens eine erste Hartschicht der Zusammensetzung (AlₐMg_{b}Cr_{c}Me_{d}BₑAXₘSiₖ)_{α}(NᵤCᵥO_{w})_{β} umfasst, mit (a+b+c+d+e+m+k) = α, (u+v+w) = β, und (α+β) =100, wobei 40 ≤α≤ 60 gilt, und wobei Me mindestens ein Element aus der Gruppe der chemischen Elemente bestehend aus:
- den Nebengruppen IVb, Vb und VIb
des Periodensystems der chemischen Elemente ist,
und AX mindestens ein Element aus der Gruppe der chemischen Elemente bestehend aus:
- den Elementen der Hauptgruppen Ia und
- den Elementen Be, Ca, Sr, Ba und
- den Elementen der Nebengruppen VIIb, VIIIb, Ib, IIb, IIIb und
- den Elementen der Gruppe der Lanthanoide
des Periodensystems der Elemente ist
wobei 0.004 ≤ m < 60, bevorzugt 0.01 ≤ m < 50 ist,
**dadurch gekennzeichnet, dass**
0.4 ≤ a < 58 und 0.04 ≤ b ≤ 12 und 18 ≤ c ≤ 42 ist.

2. Schichtsystem nach Anspruch 1, wobei 20 ≤ a < 42, oder wobei Me in einer Menge entsprechend 4 ≤ d < 54 in der Hartschicht vorhanden ist oder wobei Si in einer Menge von höchstens k = 24 in der Hartschicht vorhanden ist.

3. Schichtsystem nach einem der vorangehenden Ansprüche, wobei AX nur Li und / oder Be und / oder Ca ist, und / oder wobei AX nur Sc und / oder Y und / oder La ist, und / oder wobei AX nur mindestens ein Element aus der Gruppe der Lanthanoide ist, insbesondere nur Ce ist und / oder wobei AX ein Mischmetall ist.

4. Schichtsystem nach einem der vorangehenden Ansprüche, wobei das Schichtsystem mindestens eine zusätzliche zweite Hartschicht der Zusammensetzung (MₒSiₚAY_{q})γ(NᵣCₛOₜ)_{δ} umfasst, mit (o+p+q) = γ, (r+s+t) = δ, und (γ+δ) = 100, wobei 40 ≤ γ≤ 60 gilt, und wobei M mindestens ein Metall aus der Gruppe der chemischen Elemente bestehend aus:
- Al und
- den Elementen aus den Nebengruppen IVb, Vb, VIb
des Periodensystems der Elemente ist,
und AY mindestens ein Element aus der Gruppe der chemischen Elemente bestehend aus:
- Mn, Fe, Co, Ni, Cu und
- den Elementen der Nebengruppe IIIB und
- den Elementen der Hauptgruppe IA, IIA und IIIA und
- den Elementen der Gruppe der Lanthanoide
des Periodensystems der chemischen Elemente ist und i wobei 0.04 ≤ p < 30 ist, und / oder wobei 0.004 < q < 6 ist.

5. Schichtsystem nach Anspruch 4, wobei in der zusätzlichen zweiten Hartschicht AY zusätzlich Bor enthält und / oder wobei AY ein Mischmetall ist und / oder wobei AY ein Element aus der Gruppe der chemischen Elemente bestehend aus Y und den Lanthanoiden, insbesondere Ce und / oder La ist.

6. Schichtsystem nach einem der Ansprüche 4 oder 5, wobei 0.04 ≤ p < 30 ist, und / oder wobei 0.01 < q < 10 ist7.

7. Schichtsystem nach einem der vorangehenden Ansprüche, wobei die erste Hartschicht eine abschliessende Deckschicht des Schichtsystems ist und / oder wobei die zweite Hartschicht eine abschliessende Deckschicht des Schichtsystems ist.

8. Schichtsystem nach einem der vorangehenden Ansprüche, wobei auf der Oberfläche des Substrats mindestens eine weitere Funktionsschicht, insbesondere eine Verbundschicht, bevorzugt eine Verbundschicht aus MetₓE_{y}N_{z}, mit x > 0; y ≥ 0 und z > 0 vorgesehen ist, wobei Met mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

9. Schichtsystem nach einem der vorangehenden Ansprüche, wobei eine Zwischenschicht umfassend die Elemente Si und / oder C vorgesehen ist, und / oder wobei eine Gradienten-Mischschicht vorgesehen ist, die die Elemente Si und / oder C der Zwischenschicht und die Zusammensetzung (Alₐmg_{b}Cr_{c}Me_{d}BₑAXₘSiₖ)_{α}(NᵤCᵥO_{w})_{β} der ersten Hartschicht und /oder die Zusammensetzung (MₒSiₚAY_{q})γ(NᵣCₛOₜ)_{δ} der zweiten Hartschicht umfasst.

10. Lichtbogenverdampfungsquelle mit einem Verdampfungsmaterial als Kathode zur Erzeugung einer Oberflächenschicht auf einer Oberfläche eines Substrats durch Verdampfung des Verdampfungsmaterials mittels einer Lichtbogenentladung auf einer Verdampfungsoberfläche der Kathode, wobei das .Verdampfungsmaterial eine chemische Zusammensetzung (Al_{a'}Mg_{b'}Cr_{c'}Me_{d'}B_{e'}AXₘSiₖ,) hat, mit (a'+b'+c'+d'+e'+m'+k') = 100, und wobei Me mindestens ein Element aus der Gruppe der chemischen Elemente bestehend aus:
- den Nebengruppen IVb, Vb und VIb
des Periodensystems der chemischen Elemente ist,
und AX mindestens ein Element aus der Gruppe der chemischen Elemente bestehend aus:
- den Elementen der Hauptgruppe Ia, und
- den Elementen Be, Ca, Sr, Ba und
- den Elementen der Nebengruppen Vllb, VIIIb, Ib, IIb, IIIb und
- den Elementen der Gruppe der Lanthanoide
des Periodensystems der Elemente ist,
wobei 0.01 ≤ m' < 100, bevorzugt 0.012 ≤ m' < 80 ist,
**dadurch gekennzeichnet, dass**
1 ≤ a' < 97 und 0.1 ≤ b' ≤ 20 und 30 ≤ c' ≤ 70 ist und das Verdampfungsmaterial bevorzugt zusätzlich C und / oder N und / oder O enthält.

11. Lichtbogenverdampfungsquelle nach Anspruch 10, wobei 50 ≤ a' < 70 und / oder 0.5 ≤ b' ≤ 10 und / oder 10 ≤ d' ≤ 80 und /oder k' höchstens gleich 40 ist.

12. Lichtbogenverdampfungsquelle nach einem der Ansprüche 10 oder 11, wobei AX nur Li und / oder Be und / oder Ca ist, und / oder wobei AX nur Sc und / oder Y und / oder La ist, und / oder wobei AX nur mindestens ein Element aus der Gruppe der Lanthanoide ist, insbesondere nur Ce ist, und / oder wobei AX ein Mischmetall ist.

13. Kombinations-Verdampfungsquelle mit einem Verdampfungsmaterial bestehend aus einem Verdampfungsmaterial der ersten Verdampfungsquelle nach einem der Ansprüche 10 bis 12 und einer zweiten Verdampfungsquelle

14. Substrat, insbesondere Werkzeug, beschichtet mit einem Schichtsystem nach einem der Ansprüche 1 bis 9, wobei das Werkzeug ein Urformwerkzeug, ein Presswerkzeug, ein spanendes Werkzeug, insbesondere ein Bohrer, ein Fräser, eine Wendeschneidplatte für einen Dreh- oder Fräsprozess oder ein Hobelwerkzeug, ein Umformwerkzeug oder ein Mikrowerkzeug, insbesondere ein Mikrobohrer, eine Mikrowendeschneidplatte, ein Mikrofräser oder ein anderes Werkzeug oder Mikrowerkzeug oder ein Kunststoffwerkzeug ist, und / oder wobei das Substrat ein Verschleissteil, insbesondere ein Verschleissteil für eine Luft- oder Land gestützte Turbine, einen Motor, im Speziellen für einen Verbrennungsmotor, im speziellen eine Dichtung, ein Zahnrad, ein Kolben, Kolbenring, ein Verschleissteil für eine Textilmaschine oder ein anderes Verschleissteil ist.

## Claims

1. A layer system for the formation of a surface layer on a surface of a substrate, in particular on the surface of a tool, wherein the layer system includes at least one first hard layer of the composition (AlₐMg_{b}Cr_{c}Me_{d}BₑAXₘSiₖ)_{α}(NᵤCᵥO_{w})_{β} with (a+b+c+d+e+m+k) = α, (u+v+w) = β, and (α+β) =100, wherein 40 ≤ α ≤ 60 is true and wherein Me is at least one element of the group of the chemical elements composed of:
- the secondary groups IVb, Vb and VIb
of the periodic system of the chemical elements,
and AX is at least one element of the group of the chemical elements composed of:
- the elements of the main group Ia and
- the elements Be, Ca, Sr, Ba and
- the elements of the secondary groups VIIb, VIIIb, Ib, IIb, IIIb and
- the elements of the group of the lanthanoids,
of the periodic system of the elements
wherein 0.004 ≤ m < 60, preferably 0.01 ≤ m < 50,
**characterized in that**
0.4 ≤ a < 58 and 0.04 ≤ b ≤ 12 and 18 ≤ c ≤ 42.

2. A layer system in accordance with claim 1, wherein 20 ≤ a < 42, or wherein Me is present in a quantity corresponding to 4 ≤ d < 54 in the hard layer, or wherein Si is present in a quantity of at most k = 24 in the hard layer.

3. A layer system in accordance with any one of the preceding claims, wherein AX is only Li and/or Be and/or Ca; and/or wherein AX is only Sc and/or Y and/or La, and/or wherein AX is only at least one element of the group of the lanthanoids, in particular is only Ce and/or wherein AX is a mixed metal.

4. A layer system in accordance with any one of the preceding claims, wherein the layer system includes at least one additional second hard layer of the composition (MₒSiₚAY_{q})γ(NᵣCₛOₜ)_{δ} with (o+p+q) = γ, (r+s+t) = δ, and (γ+δ) = 100, wherein 40 ≤ γ ≤ 60 and wherein M is at least one metal of the group of the chemical elements composed of::
- Al and
- the elements of the secondary groups IVb, Vb, VIb
of the periodic system of the elements,
and AY is at least one element of the group of the chemical elements composed of:
- Mn, Fe, Co, Ni, Cu and
- the elements of the secondary group IIIB and
- the elements of the main group IA, IIA and IIIA and
- the elements of the group of the lanthanoids
of the periodic system of the chemical elements and wherein 0.04 ≤ p < 30, and/or wherein 0.004 < q < 6.

5. A layer system in accordance with claim 4, wherein in the additional second hard layer AY additionally contains boron and/or wherein AY is a mixed metal and/or wherein AY is an element of the group of the chemical elements composed of Y and the lanthanoids, in particular Ce and/or La.

6. A layer system in accordance with one of the claims 4 or 5, wherein 0.04 ≤ p < 30 and/or wherein 0.01 < q < 10.

7. A layer system in accordance with any one of the preceding claims, wherein the first hard layer is a terminal cover layer of the layer system and/or wherein the second hard layer is a terminal cover layer of the layer system.

8. A layer system in accordance with any one of the preceding claims, wherein at least one further functional layer, in particular a composite layer is provided on the surface of the substrate, preferably a composite layer of MetₓE_{y}N_{z}, with x > 0; y ≥ 0 and z > 0, wherein Met is at least one metal of the group Al, Cr, Mo, W, V, Nb, Ta, Ti, Zr, HF, Mn, Fe; Co; Ni, Li, Be, Mg, Sc, Y, La, Ce, Nd, Sm and E is an element of the group Si, B, C, O.

9. A layer system in accordance with any one of the preceding claims, wherein an intermediate layer including the elements Si and/or C is provided and/or wherein a gradient mixed layer is provided which includes the elements Si and/or C of the intermediate layer and the composition (AlₐMg_{b}Cr_{c}Me_{d}BₑAXₘSiₖ)_{α}(NᵤCᵥO_{w})_{β} of the first hard layer and/or the composition (MₒSiₚAY_{q})γ(NᵣCₛOₜ)_{δ} of the second hard layer.

10. An arc vaporization source having a vaporization material as cathode for the generation of a surface layer on a surface of a substrate by vaporization of the vapor material by means of an arc discharge on a vaporization surface of the cathode, wherein the vaporization material has a chemical composition (Al_{a'}Mg_{b'}Cr_{c'}Me_{d'}B_{e'}AX_{m'}Si_{k'}) with (a'+b'+c'+d'+e'+m'+k') = 100, and wherein Me is at least one element of the group of the chemical elements composed of :
- the secondary groups IVb, Vb and VIb
of the periodic system of the chemical elements,
and AX is at least one element of the group of the chemical elements composed of:
- the elements of the main group Ia and
- the elements Be, Ca, Sr, Ba and
- the elements of the secondary groups VIIb, VIIIb, Ib, IIb, IIIb and
- the elements of the group of the lanthanoids,
of the periodic system of the elements,
wherein 0.01 ≤ m' < 100, preferably 0.012 ≤ m' < 80,
**characterized in that**
1 ≤ a' < 97 and 0.1 ≤ b' ≤ 20 and 30 ≤ c' ≤ 70 and the vaporization material preferably additionally contains C and/or N and/or O.

11. An arc vaporization source in accordance with claim 10, wherein 50 ≤ a' < 70 and/or 0.5 ≤ b' ≤ 10 and/or 10 ≤ d' ≤ 80 and/or k' is at most equal to 40.

12. An arc vaporization source in accordance with one of the claims 10 or 11, wherein AX is only Li and/or Be and/or Ca, and/or wherein AX is only Sc and/or Y and/or La, and/or wherein AX is only at least one element of the group of the lanthanoids, in particular is only Ce, and/or wherein AX is a mixed metal.

13. A combination vaporization source composed of a vaporization material of the first vaporization source in accordance with one of the claims 10 to 12 and a second vaporization source.

14. A substrate, in particular tool, coated with a layer system in accordance with any one of the claims 1 to 9, wherein the tool is an original tool (a master tool), a press tool, a cutting tool, in particular a drill, a milling cutter, an indexable cutting insert for a turning or milling process or a planing tool, a reshaping tool or a micro-tool, in particular a micro drill, a micro indexable cutting insert, a micro miller or another tool or micro tool or a plastic tool and/or wherein the substrate is a part subjected to wear, in particular a part subjected to wear for an air or land-based turbine, a motor, in particular for a combustion engine, especially a seal, a gear, a piston, a piston ring, a part subjected to wear for a textile machine or another part subjected to wear.

## Revendications

1. Système de couches pour la formation d'une couche superficielle sur une surface d'un substrat, en particulier sur la surface d'un outil, le système de couches comprenant au moins une première couche dure de composition (AlₐMg_{b}Cr_{c}Me_{d}BₑAXₘSiₖ)_{α}(NᵤCᵥO_{w})_{β}, avec (a+b+c+d+e+m+k) = α, (u+v+w) = β et (α+β) = 100, avec 40 ≤ α ≤ 60, Me étant au moins un élément du groupe des éléments chimiques constitué
- des groupes secondaires IVb, Vb et VIb du Tableau Périodique des Eléments chimiques,
et AX est au moins un élément du groupe des éléments chimiques constitué
- des éléments des groupes principaux Ia, et
- des éléments Be, Ca, Sr, Ba et
- des éléments des groupes secondaires VIIb, VIIIb, Ib, IIb, IIIb, et
- des éléments du groupe des lanthanides du Tableau Périodique des Eléments,
avec 0,004 ≤ m < 60, de préférence 0,01 ≤ m < 50,
**caractérisé en ce que** 0,4 ≤ a < 58 et 0,04 ≤ b ≤ 12 et 18 ≤ c ≤ 42.

2. Système de couches selon la revendication 1, dans lequel 20 ≤ a < 42, ou dans lequel Me est présent dans la couche dure en une quantité correspondant à 4 ≤ d < 54, ou dans lequel Si est présent dans la couche dure en une quantité d'au plus k = 24.

3. Système de couches selon l'une des revendications précédentes, dans lequel AX est seulement Li et/ou Be et/ou Ca, et/ou dans lequel AX est seulement Sc et/ou Y et/ou La, et/ou dans lequel AX est seulement au moins un élément du groupe des lanthanides, en particulier est seulement Ce, et/ou dans lequel AX est un mischmétal.

4. Système de couches selon l'une des revendications précédentes, dans lequel le système de couches comprend au moins une deuxième couche dure supplémentaire de composition (MₒSiₚAY_{q})γ(NᵣCₛOₜ)δ, avec (o+p+q) = y, (r+s+t) δ et (γ+δ) = 100, avec 40 ≤ γ ≤ 60, et dans lequel M est au moins un métal du groupe des éléments chimiques constitué
- d'Al et
- des éléments des groupes secondaires IVb, Vb, VIb du Tableau Périodique des Eléments,
et AY est au moins un élément du groupe des éléments chimiques constitué
- de Mn, de Fe, de Co, de Ni, de Cu, et
- des éléments du groupe secondaire IIIB, et
- des éléments du groupe principal IA, IIA et IIIA, et
- des éléments du groupe des lanthanides du Tableau Périodique des Eléments Chimiques, et dans lequel 0,04 ≤ p < 30 et/ou dans lequel 0,004 ≤ q < 6.

5. Système de couches selon la revendication 4, dans lequel, dans la deuxième couche dure supplémentaire, AY contient en outre du bore, et/ou dans lequel AY est un mischmétal, et/ou dans lequel AY est un élément du groupe des éléments chimiques constitué de Y et des lanthanides, en particulier de Ce et/ou de La.

6. Système de couches selon l'une des revendications 4 ou 5, dans lequel 0,04 ≤ p < 30, et/ou dans lequel 0,01 < q < 10.

7. Système de couches selon l'une des revendications précédentes, dans lequel la première couche dure est une couche de couverture de finition du système de couches et/ou dans lequel la deuxième couche dure est une couche de couverture de finition du système de couches.

8. Système de couches selon l'une des revendications précédentes, dans lequel il est prévu sur la surface du substrat au moins une couche fonctionnelle supplémentaire, en particulier une couche composite, de préférence une couche composite constituée de MetₓE_{y}N_{z}, avec x > 0, y ≥ 0 et z > 0, dans lequel Met est un moins un métal du groupe Al, Cr, Mo, W, V, Nb, Ta, Ti, Zr, Hf, Mn, Fe, Co, Ni, Li, Be, Mg, Sc, Y, La, Ce, Nd, Sm, et E est un élément du groupe Si, B, C, O.

9. Système de couches selon l'une des revendications précédentes, dans lequel il est prévu une couche intermédiaire comprenant les éléments Si et/ou C, et/ou dans lequel il est prévu une couche mixte à gradient, qui comprend les éléments Si et/ou C de la couche intermédiaire, et a la composition (AlₐMg_{b}Cr_{c}Me_{d}BₑAXₘSiₖ)_{α}(NᵤCᵥO_{w})β de la première couche dure et/ou la composition (MₒSiₚAY_{q})γ(NᵣCₛOₜ)δ de la deuxième couche dure.

10. Source d'évaporation par décharge d'arc, avec un matériau d'évaporation en tant que cathode, pour la production d'une couche superficielle sur une surface d'un substrat par évaporation du matériau d'évaporation à l'aide d'une décharge d'arc sur une surface d'évaporation de la cathode, dans laquelle le matériau d'évaporation a une composition chimique (Al_{a'}Mg_{b'}Cr_{c'}Me_{d'}B_{e'}AX_{m'}Si_{k'}), avec (a'+b'+c'+d'+e'+m'+k') = 100, et dans lequel Me est au moins un élément du groupe des éléments chimiques constitué
- des groupes secondaires IVb, Vb et VIb du Tableau Périodique des Eléments Chimiques,
et AX est au moins un élément du groupe des éléments chimiques constitué
- des éléments du groupe principal Ia, et
- des éléments Be, Ca, Sr, Ba, et
- des éléments des groupes secondaires VIIb, VIIIb, Ib, IIb, IIIb, et .
- des éléments du groupe des lanthanides du Tableau Périodique des Eléments,
où 0,01 ≤ m' < 100, de préférence 0,012 ≤ m' < 80,
**caractérisé en ce que** 1 ≤ a' < 97 et 0,1 ≤ b' ≤ 20 et 30 ≤ c' ≤ 70, et que le matériau d'évaporation contient de préférence en outre C et/ou N et/ou O.

11. Source d'évaporation par arc selon la revendication 10, dans laquelle 50 ≤ a' < 70 et 0,5 ≤ b' ≤ 10 et 10 ≤ d' ≤ 80, et/ou k' est au plus égal à 40.

12. Source d'évaporation par arc selon l'une des revendications 10 ou 11, dans laquelle AX est seulement Li et/ou Be et/ou Ca, et/ou dans laquelle AX est seulement Sc et/ou Y et/ou La, et/ou dans laquelle AX est seulement au moins un élément du groupe des lanthanides, en particulier seulement Ce, et/ou dans laquelle AX est un mischmétal.

13. Source d'évaporation combinée, comportant un matériau d'évaporation constitué d'un matériau d'évaporation de la première source d'évaporation selon l'une des revendications 10 à 12, et d'une deuxième source d'évaporation.

14. Substrat, en particulier outil, revêtu d'un système de couches selon l'une des revendications 1 à 9, l'outil étant un outil de façonnage, un outil de presse, un outil à enlèvement de copeaux, en particulier un foret, une fraise, une plaquette amovible pour une opération de tournage ou de fraisage ou un outil de rabotage, un outil de façonnage ou un micro-outil, en particulier un microforet, une microplaquette amovible, une microfraise, ou un autre outil ou micro-outil, ou un outil en plastique, et/ou le substrat étant une pièce d'usure, en particulier une pièce d'usure pour une turbine aérienne ou terrestre, pour un moteur, en particulier pour un moteur à combustion interne, en particulier un joint d'étanchéité, une roue dentée, un piston, un segment de piston, une pièce d'usure pour une machine textile, ou une autre pièce d'usure.
